# EUROPEAN PATENT SPECIFICATION

(11) **EP 4 384 397 B1**
(45) Date of publication and mention of the grant of the patent: **03.12.2025**
(21) Application number: 22754401.2
(22) Date of filing: 22.07.2022
(51) Int. Cl.: B41F 15/04, B41M 3/00, B41M 3/14, B41M 5/00, B42D 25/23, B42D 25/26, B41J 2/01

(54) **VARIABLE-APPEARANCE LASER MARKING OVER PRINTED LAYERS**
LASERMARKIERUNG MIT VARIABLEM ERSCHEINUNGSBILD ÜBER BEDRUCKTEN SCHICHTEN
MARQUAGE LASER À APPARENCE VARIABLE SUR COUCHES IMPRIMÉES

(30) Priority: 10.08.2021 EP 21306109
(43) Date of publication of application: 19.06.2024
(73) Proprietor: THALES DIS FRANCE SAS, 92190 Meudon (FR)
(72) Inventor: LARINA, Nina, 13470 CARNOUX EN PROVENCE (FR); SUBRA, Sebastien, 13390 AURIOL (FR); GOURDEN, Yannick, 13600 CEYRESTE (FR); ANDRIEUX, David, 13009 MARSEILLE (FR); RENOUARD, Jérémy, 83120 SAINTE MAXIME (FR)
(74) Representative: Castelo, Jérôme
(86) International application number: PCT/EP2022/070706
(87) International publication number: WO 2023/016781

(56) References cited:
- JP-A- 2016 071 290
- US-A1- 2020 180 346
- US-A1- 2020 331 284

## Description

### TECHNICAL FIELD

The present invention relates to a data carrier according to claim 1, a security document comprising or consisting of such a data carrier according to claim 13, a method of producing a data carrier according to claim 14, and a method of personalizing a data carrier according to claim 15.

### PRIOR ART

Laser marking is one of the most frequent ways of personalizing various data carriers such as cards and ID documents. A commonly used laser personalization equipment typically involves only one laser source, such as a 1064nm near-infrared laser, and usually produces only monochrome marks, e.g. black or grey personalized marking in specifically provided laser-engravable material layers. Marking in more than one colour (or generally in more than one appearance) requires more sophisticated and/or more expensive solutions, each suitable with limited choice of processes and products only. US2020/331284, US2020/180346 and JP2016071290 disclose technologies for personalization of data carriers.

### SUMMARY OF THE INVENTION

It is an object of the present invention to provide a data carrier comprising a multiple-appearance personalization element that overcomes the drawback of the state of the art. In particular it is an object to provide a data carrier comprising a multiple-appearance personalization element that is easily and widely realizable.

This object is achieved with a data carrier according to claim 1. That is, a data carrier extending along an extension direction is provided, wherein the data carrier comprises at least one carrier body and at least one processing layer. The processing layer, at least in an unprocessed state of the processing layer, comprises one or more reactive elements and one or more unreactive elements. The reactive elements are configured to interact with impinging electromagnetic radiation upon a processing of the processing layer. The processing layer, in a processed state of the processing layer, comprises one or more reacted elements being generated from the reactive elements. The processing layer in the processed state furthermore comprises one or more further reacted elements being generated from one or more of the unreactive elements upon the interaction of the reactive elements with the impinging electromagnetic radiation, and furthermore comprises one or more unreactive elements remaining non-interacting. The processing layer in the processed state furthermore comprises at least one personalization element, which personalization element comprises or consists of the non-interacting unreactive elements.

That is, the processing layer is preferably configured to adapt at least an unprocessed state and a processed state. The unprocessed state is a state wherein the processing layer has not been irradiated with electromagnetic radiation. The processed state in turn is a state wherein the processing layer has been irradiated with electromagnetic radiation. After an irradiation of electromagnetic radiation onto the processing layer, the personalization element in the processing layer can be generated. The electromagnetic radiation is preferably emitted by a specific source of electromagnetic radiation, such as a laser. In other words, the personalization element preferably is a laser-generated personalization element. Said laser-generated personalization element can also be referred to as laser marking. The laser can be an IR laser and/or a UV laser and/or a VIS laser. The electromagnetic radiation being irradiated onto the processing layer therefore preferably comprises wavelengths in the infrared and/or the ultraviolet and/or the visible range of the electromagnetic spectrum. It is particularly preferred to generate the personalization element with a pulsed near-infrared (NIR) laser, such as for instance Nd:YAG laser or Nd:YVO₄ laser at their main emitted wavelength 1064nm.

At least in the unprocessed state of the processing layer, the processing layer comprises unreactive elements and reactive elements. Upon an irradiation of the electromagnetic radiation, the reactive elements interact with said electromagnetic radiation and form reacted elements. Said reactive element thus preferably correspond to radiation-sensitive, in particular to laser-sensitive elements, see also further below.

The unreactive elements however are preferably not sensitive to radiation. Instead, the unreactive elements are preferably sensitive or responsive to the interaction of the reactive elements with the electromagnetic radiation, see also further below. As such, the unreactive elements can be said to be indirectly responsive or sensitive to electromagnetic radiation, whereas the reactive elements can be said to be directly responsive or sensitive to electromagnetic radiation. In fact, the unreactive elements are preferably arranged and/or configured such that at least some of them are transformed into further reacted elements by the impact of interaction of the reactive elements with the electromagnetic radiation.

This indirect interaction of the unreactive elements is preferably caused by reaction energy being generated during the interaction of the reactive elements with the electromagnetic radiation, for instance during exothermic reactions and/or heat evolution. In other words, the reactive elements are preferably configured to generate reaction energy when irradiated with electromagnetic radiation. For example, and as will be explained in greater detail below, the reactive elements can be radiation-sensitive elements such as radiation-absorbing elements, which are ablated or evaporated upon the irradiation of the electromagnetic radiation. For instance, and as will be explained in greater detail further below, an ink producing reactive elements (e.g. an element being a drop of ink or multiple drops, optionally furthermore hardened into a print, and optionally furthermore ablated by a laser), and another ink producing unreactive elements (same principle) could be provided. That is, a reactive element can be seen as a set of components forming together a preferably continuous spatial entity that reacts to impinging electromagnetic radiation with the generation of a preferably single reacted element. Besides, it is noted that the reactive element can be produced in a single process step during the manufacturing of the data carrier. It is furthermore important to note that the expressions "reactive" and "unreactive" can be linked to the employed radiation source; the reactivity and thus the nature of the elements can change for a different source.

The interaction of the reactive elements with the electromagnetic radiation preferably generates reaction energy, for instance heat. Said reaction energy in turn acts on or affects not only the reactive elements themselves (for example resulting in their ablation or evaporation), but also one or more unreactive elements, whereupon said unreactive elements form the above-mentioned further reacted elements. As will also be explained in greater detail below, said further reacted elements could be ablated or evaporated elements, and wherein their ablation or evaporation is effectuated by the reaction energy generated during the interaction of the reactive elements with the electromagnetic radiation. The unreactive elements in turn are preferably non-radiation-sensitive elements such as non-radiation absorbing elements, wherein the irradiation of electromagnetic radiation does not affect them directly.

Hence, the irradiation of electromagnetic radiation onto the processing layer preferably results in an interaction of the impinged reactive elements, wherein the thus generated interaction energy acts upon the unreactive elements such, that further reacted elements are formed from the unreactive elements in an area of influence of the interaction energy. Regarding the temporal aspect, it is noted that this interaction of the evolved heat with the surrounding material can take place immediately, preferably in the millisecond time range or shorter. Unreactive elements located in the area of influence of the interaction energy are preferably unreactive elements that are arranged in vicinity to the interacting reactive elements. Those unreactive elements that are located outside the area of influence of the interaction energy remain unaffected, i.e. these elements constitute the non-interacting unreactive elements. A preferred area of influence of the interaction energy is in the distance range within 100 micrometers around the reactive element in question, more preferably in the range of 50 micrometers.

The personalization element according to the invention comprises or consists of these non-interacting unreactive elements or unaffected unreactive elements, respectively. Consequently, a particular non-interacting unreactive element in the processed state of the processing layer and the corresponding unreactive element in the unprocessed state of the processing layer are preferably identical.

Moreover, since at least some of the unreactive elements are transformed into further reacted elements, a number or density or frequency or occurrence of the unreactive elements in the unprocessed state of the processing layer is preferably higher than a number or density or frequency or occurrence of the unreactive elements in the processed state of the processing layer. Likewise, since at least some of the reactive elements are transformed into reacted elements, a number or density or frequency or occurrence of the reactive elements in the unprocessed state of the processing layer is preferably higher than a number or density of frequency or occurrence of the reactive elements in the processed state of the processing layer.

Since the reactive elements interact upon their impingement with electromagnetic radiation, selective irradiation of electromagnetic radiation enables selective generation of the personalization element.

It should be noted that only some of the reactive elements can be irradiated with electromagnetic radiation or all of the reactive elements can be irradiated with electromagnetic radiation. As such, it is conceivable that the personalization element furthermore comprises one or more reactive elements. It is additionally also conceivable that the personalization element furthermore comprises one or more reacted elements and/or one or more further reacted elements. For instance, if the interaction with impinging electromagnetic radiation results in generation of reacted elements or further reacted elements of appearances such as colours being different from the colours of the reactive elements and the unreactive elements, the generated personalization element can be said to comprise the non-interacting unreactive elements of the initial appearance (here: initial colour), the further reacted elements of a different appearance (here: different colour), the reactive elements of the initial appearance (here: initial colour), and the reacted elements of a different appearance (here: different colour).

The carrier body preferably corresponds to a card body, or a passport datapage, as it is commonly known in the industry of security documents. That is, it is preferred that the carrier body comprises or consists of one or more layers comprising or consisting of polymers and/or plastics, preferably thermoplastics, particularly preferably polycarbonate and/or polyvinyl chloride and/or polyethylene terephthalate. One or more of these layers can be transparent or non-transparent. It is furthermore conceivable that the carrier body comprises one or more layers comprising or consisting of metallic compounds. For instance, one or more metallic layers can be embedded between one or more transparent plastic layers.

The processing layer in its unprocessed state preferably exhibits a first appearance and in its processed state exhibits a second appearance, wherein said first appearance and said second appearance differ from one another. Additionally or alternatively it is preferred that one or more unreactive elements are of a first appearance and that at least one or more further unreactive elements are of at least a further appearance, wherein said first appearance and said further appearance differ from one another. For instance, one or more unreactive elements can have a black colour and one or more further unreactive elements can have a white colour. Additionally or alternatively it is preferred that one or more non-interacting unreactive elements are of a first appearance and that at least one or more further non-interacting unreactive elements are of at least a further appearance, wherein said first appearance and said further appearance differ from one another. For instance, one or more non-interacting unreactive elements can be cyan in colour and one or more further non-interacting elements can be magenta in colour. These different appearances preferably differ along a horizontal direction, i.e. along a transverse direction running perpendicularly to the extension direction.

It should be noted that the transverse direction can be seen as a horizontal direction running parallel to a surface of the data carrier, and that the extension direction can be seen as a vertical direction running perpendicularly to said surface of the data carrier and said horizontal direction, respectively. The transverse direction can furthermore be seen as running within a horizontal plane running through the surface of the data carrier and the extension direction can furthermore be seen as running within a vertical plane being perpendicular to the horizontal plane. Explanations made herein regarding an arrangement along the transverse direction can likewise be understood as an arrangement along the horizontal direction and/or within the horizontal plane. Likewise, explanations made herein regarding an arrangement along the transverse direction can likewise be understood as an arrangement along the vertical direction and/or within the vertical plane.

The expression "appearance" can be widely understood as detectability or readability, said detectability or readability not necessarily being restricted to conventional visibility by human eye, such as having different colours or providing specific visual effects, such as for instance pearlescent colours. Instead, appearances provided by wider-range optical effects which may be undetectable by naked eye, such as when using UV- or IR-fluorescent inks, or specific IR absorbing / reflecting inks, or inks being otherwise detectable in the wavelength ranges invisible to human eye; or tactile effects, detectable on touch or using a profilometric device, are likewise conceivable.

In the unprocessed state of the processing layer the first appearance of the processing layer is preferably provided by at least the reactive elements and the unreactive elements. In the processed state of the processing layer the second appearance of the processing layer is preferably provided by at least the non-interacting unreactive elements, and possibly additionally also by the reactive elements and/or the reacted elements and/or the further reacted elements. Other components of the data carrier can contribute to the appearance of the processing layer in the processed state and/or the unprocessed sate as well. For instance, and as will be explained in greater detail further below, the data carrier can comprise at least one background layer, and wherein the appearance of said background layer may also impact the overall appearance of the processing layer.

It is furthermore preferred that the unreactive elements are of different appearances as well. In fact, it is particularly preferred that one or more unreactive elements are of a first appearance such as a first colour, e.g. cyan, that one or more further unreactive elements are of a second appearance such as a second colour, e.g. magenta, that one or more further unreactive elements are of a third appearance such as a third colour, e.g. yellow, etc.

Likewise, it is preferred that one or more non-interacting unreactive elements are of a first appearance such as a first colour, e.g. cyan, that one or more further non-interacting unreactive elements are of a second appearance such as a second colour, e.g. magenta, that one or more further non-interacting unreactive elements are of a third appearance such as a third colour, e.g. yellow, etc.

For the sake of completeness, it is once more noted that appearances in the form of ink colours are only examples, and reactive elements may not necessarily be black or white, and unreactive elements might not necessarily be of chromatic colour. Any of them can be colourless, have a special effect, etc. to this end it is preferred that these elements are configured such, that their reactivity matches the electromagnetic radiation.

It is likewise conceivable that one or more reactive elements are of a first appearance and at least one or more further reactive elements are of at least a further appearance, the first appearance and further appearance differing from one another. For instance, the one or more reactive elements of the first appearance could correspond to black reactive ink and the one or more further reactive elements of the second appearance could correspond to white reactive ink.

The reactive elements and/or the unreactive elements are preferably regularly or irregularly distributed in the processing layer. Additionally or alternatively, the non-interacting unreactive elements and/or the reacted elements and/or the further reacted elements are preferably regularly or irregularly distributed in the processing layer. Said regular or irregular distribution is defined preferably with respect to the extension direction and/or with respect to the transverse direction running perpendicularly to the extension direction.

The reactive elements and/or the unreactive elements and/or the non-interacting unreactive elements and/or the reacted elements and/or the further reacted elements can be provided in a gradient with respect to the extension direction and/or with respect to a transverse direction extending perpendicularly to the extension direction.

Alternatively, the reactive elements and/or the unreactive elements and/or the non-interacting unreactive elements and/or the reacted elements and/or the further reacted elements can be uniformly distributed with respect to the extension direction and/or with respect to a transverse direction extending perpendicularly to the extension direction.

A gradient in the reactive elements and/or the unreactive elements and/or the non-interacting unreactive elements and/or the reacted elements and/or the further reacted elements is preferably an arrangement where the appearance and/or the size and/or the spatial distribution of the reactive elements and/or of the unreactive elements and/or of the non-interacting unreactive elements and/or of the reacted elements and/or of the further reacted elements changes with distance along the extension direction and/or along the transverse direction running perpendicularly to the extension direction. Said modifications in the arrangement can also be seen as a variation in number or in density of or in spacing between neighbouring reactive elements and/or unreactive elements and/or non-interacting unreactive elements and/or reacted elements and/or further reacted elements with the distance along the extension direction and/or the transverse direction. For example, an element size such as an ink drop size or a printed dot size can vary along the extension direction and/or the transverse direction. Likewise conceivable are areas of different spatial densities, i.e. more or less of these elements in different areas of the printing/processing layer with respect to the extension direction and/or the transverse direction. Hence, for example, when the elements are coloured, provision of these elements in a gradient can be seen as modulation of a halftoning effect such as it is known in conventional printing. A changing appearance is preferably a change in colour. Hence, the gradient preferably is a colour gradient. However, it is also conceivable that the changing appearance can be detectable only using specific visualization or detection tools, such as for instance an IR camera.

The arrangement or appearance can be changed continuously or discontinuously. A continuously changing arrangement is understood as changes e.g. in the number or density of these elements or the spacing between neighbouring elements that varies gradually along a chosen direction, e.g. a doubling of the number of unreactive elements per distance unit with respect to the extension direction and/or the transverse direction. "Extreme value" points or lines, and inversion points or lines along the chosen direction, in particular along the chosen horizontal plane and/or vertical plane, are also conceivable.

For instance, a straight "inversion line" or max line or min line could be placed perpendicularly to the direction of the gradient (while still remaining in the plane of the data carrier), or the line can compose a figure (e.g. a curve, a circle) etc. It is even conceivable that a sort of non-personalized "watermark"-type or extra text or figure is provided in addition to the personalization element.

A discontinuously changing arrangement is understood as single-point changes between the areas of uniform arrangement e.g. in the number or density of these elements or the spacing between neighbouring elements, e.g. different numbers of unreactive elements per distance unit with respect to the extension direction and/or the transverse direction. A continuously changing appearance is understood as the appearance, such as the colour of these elements, that varies continuously with position so as to produce smooth colour (or appearance) transitions. A discontinuously changing appearance is understood as the appearance, such as the colour of these elements, that varies discontinuously with position such that no smooth colour transition is generated but simply differently coloured elements are provided.

Hence, the data carrier according to the invention can comprise a personalization element exhibiting a gradient that is not generated by means of laser irradiation parameters such as e.g. varying laser beam power or varying laser frequencies with the distance, but where the appearance gradient and/or variable appearance is generated by the elements constituting the processing layer and the personalization element, respectively. Consequently, the present invention enables different types of personalization results or effects that can be generated via a single marking operation and/or using a same source of electromagnetic radiation. Thus, it can be possible that these different types of personalization can even be achieved without a modification of the laser marking parameters across the marking area.

Non-interacting unreactive elements and/or reacted elements and/or further reacted elements being distributed uniformly with respect to the extension direction and/or with respect to the transverse direction are preferably provided with an unchanging number or density or size or spacing between neighbouring elements and/or with an unchanging appearance such as a same colour with respect to the extension direction and/or the transverse direction.

To achieve an appearance gradient in the personalization element, the reactive elements can be provided in a gradient and the unreactive elements can be provided uniformly with respect to the extension direction and/or a transverse direction running perpendicularly with respect to the extension direction. Alternatively, the unreactive elements can be provided in a gradient and the reactive elements can be provided uniformly with respect to the extension direction and/or a transverse direction running perpendicularly with respect to the extension direction. In addition, it is conceivable that both are provided in gradients.

In a preferred configuration of elements, where the reactive elements are represented with a laser-reactive black ink, and unreactive elements are represented with unreactive inks of different chromatic colours, the provision of black ink in a gradient along with a uniform arrangement of i.e. a uniform level of another colour, yields a personalization element with a gradient of said other colour.

In the same preferred configuration of elements, the provision of unreactive elements in a gradient such as unreactive elements constituting a multiple-colour gradient along with a uniform arrangement of the reactive elements such as a uniform level of black ink creates a personalization element exhibiting a multiple-colour gradient after removing the black ink along with some part of the other colours of the unreactive elements.

However, and as mentioned earlier, it is not necessary that all reactive elements are removed. Instead, it is conceivable that at least some reactive elements remain in the processing layer and are part of the personalization element.

In the unprocessed state of the processing layer the amount of unreactive elements preferably equals or is different from the amount of reactive elements. Additionally or alternatively, in the unprocessed state of the processing layer the amount of reactive elements preferably is at least 10 % or more, more preferably at least 20 % or more, particularly preferably at least 25 % or more, of the total amount of reactive elements and unreactive elements.

It is furthermore preferred that the reactive elements are configured such, that their interaction with electromagnetic radiation affects the amount of the unreactive elements that corresponds to at least half of the amount of the impacted reactive elements; the amount being considered by quantity or by volume or by area of coverage with respect to the extension direction, etc. It is particularly preferred that a certain amount of reactive elements affects at least an equal amount of unreactive elements upon the irradiation of these reactive elements with electromagnetic radiation.

The carrier body preferably comprises a top surface, and wherein the processing layer is arranged on the top surface of the carrier body.

When seen along the extension direction, the carrier body is arranged after the processing layer. Hence, and as will be explained in greater detail further below, since the processing layer is preferably applied by a suitable conventional material deposition technique such as printing, it is preferred that the processing layer corresponds to a surface print. The personalization element can thus be seen as a laser marking in a surface print of a data carrier.

The personalization element can comprise a relief structure, in fact a relief structure in a surface of the personalization element, i.e. a surface relief structure. The relief structure is preferably provided by the non-interacting unreactive elements and possibly furthermore by the reactive elements and/or the reacted elements and/or the further reacted elements. Additionally or alternatively, the relief structure can be provided in a gradient with respect to the extension direction and/or with respect to a transverse direction extending perpendicularly to the extension direction.

The relief structure preferably provides a tactile effect. In fact, since the personalization element is preferably provided on a top surface of the data carrier, it is touchable, and thereby provides a tactile effect to a person touching it.

The relief structure is understood as a structure comprising recesses and elevations extending along the extension direction. Said recesses and elevations are preferably formed by reacted elements and/or further reacted elements in the form of ablated elements and/or evaporated elements, i.e. the removal of the reactive elements and/or the unreactive elements from the processing layer preferably generates a relief structure in the processing layer.

A gradient in the relief structure is preferably a change of arrangement and/or an extension of the recesses and/or elevations with distance along the extension direction and/or along the transverse direction running perpendicularly to the extension direction. Said change of arrangement can again be seen as a change in number or density of or spacing between neighbouring recesses and/or elevations with the distance along the extension direction and/or the transverse direction. An extension of the recess or the elevation with regard to the extension direction can be seen as a depth of the recess or a length of the elevation. An extension of the recess or the elevation with regard to the transverse direction can be seen as a width of recess or elevation. A changing extension can be seen as change in depth or length or width with respect to the transverse direction, e.g. recesses becoming longer or shorter or wider or narrower with distance. Said change of arrangement or extension can occur continuously or discontinuously as has been described above.

A gradient in the relief structure is particularly preferably a consequence of the change of arrangement of the reactive elements and/or unreactive elements and/or non-interacting unreactive elements and/or reacted elements and/or further reacted elements being provided in a gradient with respect to the extension direction and/or with respect to a transverse direction extending perpendicularly to the extension direction as described above.

The processing layer is preferably applied via conventional printing and is preferably a print, more preferably a multi-colour print. The reactive element is preferably radiation-sensitive and/or radiation-absorbing and/or radiation-scattering element initially provided in the form of an ink, which is printed and stabilized and/or dried and/or cured in one of the conventional ways known in the art. The reactive ink may include such radiation-absorbing or radiation-scattering components as a reactive pigment and/or a reactive additive and/or a reactive colorant. The unreactive element is preferably also a printed element, which is non-radiation-sensitive and/or non-radiation-absorbing and/or non-radiation-scattering, and is initially provided in the form of a printable ink. It is particularly preferred that the reactive and/or unreactive elements are provided as liquid inks and are applied via inkjet or dispensing technique; however, using other forms of inks and printing methods is also conceivable. The reactive and/or unreactive elements may also be provided as special-effect inks, such as thermochromic ink or photochromic ink or pearlescent ink, or ink with metallic particles, or the like. The reacted element and/or the further reacted element can be a bleached element and/or an ablated element and/or an evaporated element and/or a colour-changed element and/or an opaque element and/or a bubbling element and/or a bulging element and/or a blurry element and/or a fuzzy element.

That is, the processing layer preferably corresponds to a print and particularly preferably to a multi-colour print. To this end it is preferred that said print, in particular multi-colour print, is composed of unreactive elements being of a different appearance, in particular of different colours as mentioned earlier. Consequently, the personalization element comprising or consisting of the non-interacting unreactive elements preferably corresponds to a print and particularly preferably to a multi-colour print as well. Preferred reactive elements are selected so that their optical properties such as absorption and/or scattering wavelength ranges match the optical range of the impinging electromagnetic radiation. For instance, to match a conventional NIR laser source, preferred reactive elements can be IR-absorbing pigments, for instance carbon black that absorbs electromagnetic radiation across a large wavelength range including the entire visible and NIR ranges.

It is furthermore preferred that the reactive elements such as the black pigments are printed along with the unreactive elements such as non-absorbing and non-scattering inks preferably of different colour, e.g. cyan, magenta, yellow or colourless varnish. Upon the irradiation of electromagnetic radiation on said print, the removal of the black pigments carries away some of the coloured inks as well, wherein a personalization element of a certain colour being constituted by the colours of the remaining coloured inks remain. Or, a colourless varnish could be present, which remains colourless also after the impingement of the electromagnetic radiation, where however a surface structure as described earlier is created, etc.

The processing layer being a print preferably comprises or consists of a mixture of unreactive elements and reactive elements such as a mixture of non-absorbing and/or non-scattering inks and absorbing and/or scattering inks with regard to the electromagnetic radiation of the selected radiation source.

It is furthermore preferred that the unreactive elements and the reactive elements are provided according to a predetermined arrangement. Said predetermined arrangement preferably is a printing order and/or an ink drop distribution. As the easiest process option, in case of using a standard printing equipment to print the unreactive elements and the reactive elements, it is fully possible to use the said printing order and/or ink drop distribution that is automatically determined by the printer software provided by default. For instance, if the processing layer, in particular the unreactive elements and the reactive elements, are provided in a standard mode of inkjet printing in colours, an ink drop distribution can be determined according to a printer-controlled algorithm for a selected ICC profile.

However, a manual setup of the predetermined arrangement such as the printing order and/or the ink drop distribution is likewise conceivable.

If targeting a certain appearance of the personalization element such as its colour or colours, its brightness, its saturation, surface relief effect, UV-fluorescence intensity, etc., the predetermined arrangement and thus the processing layer in the unprocessed state preferably comprises correspondingly selected levels of the colour or colours of the unreactive elements and of the reactive elements such as the compatible black ink.

A conceivable unit size of the unreactive elements and/or the reactive elements and/or the non-interacting unreactive elements and/or the reacted elements and/or the further reacted elements preferably is in the range of 30 micrometers to 1000 micrometers, more preferably in the range of 150 micrometers to 500 micrometers. A conceivable unit size of the unreactive elements and/or the reactive elements and/or the non-interacting unreactive elements and/or the reacted elements and/or the further reacted elements preferably is 30 micrometer or more, more preferably 150 micrometer or more.

The personalization element preferably has the shape of an image and/or a series of alphanumeric characters. Non-exhaustive examples of an image are a portrait or photograph or biometric information such as a fingerprint e.g. of the holder of the data carrier, an outline of a country, a state coat of arms, a state flag, a signature panel, geometric objects such as lines, circles, a graphical representation of an encoded information such as a bar code or a QR code, etc. Non-exhaustive examples of data represented by alphanumeric characters are a date of birth, a name, a social security number e.g. of the holder of the data carrier, an expiry date, etc. The personalization element preferably serves the purpose of attributing personalized information such as personal data of the holder of the data carrier to the data carrier.

Since the achievable size of the unreactive elements and/or the reactive elements and/or the non-interacting unreactive elements and/or the reacted elements and/or the further reacted elements may be configured in the micrometer range, the resulting micro-scale personalization element can be seen as a microtext or a microprint. It is of course possible to have the element of sizes of several millimetres or several centimetres.

The processing layer preferably is continuous or intermittent with respect to the extension direction and/or with respect to a transverse direction running perpendicularly to the extension direction.

A thickness of the processing layer with respect to the extension direction preferably is in the range of 1 micrometer to 100 micrometers, more preferably in the range of 5 micrometers to 50 micrometers, and particularly preferably in the range of 10 micrometers to 20 micrometers.

The data carrier preferably further comprises at least one background layer, wherein the background layer is arranged after the processing layer with respect to the extension direction. The background layer is preferably configured to reflect and/or scatter and/or absorb impinging electromagnetic radiation. However, it is likewise conceivable that the background layer is inactive towards the electromagnetic radiation and, for instance, merely serves the purpose of providing a solid support.

The background layer can be non-transparent or transparent and/or a laser-markable layer and/or can comprise at least one metallic compound such as a metal foil.

The background layer preferably is part of the carrier body. In other words, the carrier body preferably comprises at least one background layer.

In another aspect a security document comprising or consisting of at least one data carrier as described above is provided. The security document preferably is a banking card, an identity card, a passport, a smart card, a driving licence, a data page or the like.

Explanations made herein regarding the data carrier *per se* likewise apply to the security document comprising or consisting of the data carrier and vice versa.

In another aspect a method of producing a data carrier, preferably a data carrier as described above, is provided. The method comprises the steps of i) providing at least one carrier body, and ii) providing at least one processing layer. The processing layer, at least in an unprocessed state of the processing layer, comprises one or more reactive elements and one or more unreactive elements. The reactive elements are configured to interact with impinging electromagnetic radiation upon a processing of the processing layer. The processing layer, in a processed state of the processing layer, comprises one or more reacted elements being generated from the reactive elements. The processing layer in the processed state furthermore comprises one or more further reacted elements being generated from one or more of the unreactive elements upon the interaction of the reactive elements with the impinging electromagnetic radiation and furthermore comprises one or more unreactive elements remaining non-interacting. The processing layer in the processed state furthermore comprises at least one personalization element, which personalization element comprises or consists of the non-interacting unreactive elements.

Any explanations made herein with regard to the data carrier or the security document preferably likewise apply to the method of producing the data carrier and vice versa.

The carrier body is preferably provided by means commonly known in the state of the art. That is, it is preferred to provide one or more layers comprising or consisting of polymers and/or plastics, preferably thermoplastics, particularly preferably polycarbonate and/or polyvinyl chloride and/or polyethylene terephthalate, and to connect these layers to one another. A connection is preferably achieved via lamination. After the carrier body is generated, it is preferred to provide the processing layer on the carrier body, in particular on a top surface of the carrier body.

The processing layer is preferably provided by printing, in particular by applying printing inks, with comprising the reactive elements and the unreactive elements. To this end, it is preferred that standard printing techniques are used such as a digital printing, in particular inkjet printing. Other printing techniques such as offset or screen printing are however likewise conceivable.

It is furthermore preferred that the ink is stabilized and/or cured and/or dried after its arrangement on the carrier body.

In another aspect a method of personalizing a data carrier, preferably a data carrier as described above, is provided. The method comprises the steps of i) providing at least one carrier body, and ii) providing at least one processing layer. The processing layer, at least in an unprocessed state of the processing layer, comprises one or more reactive elements and one or more unreactive elements. The reactive elements are configured to interact with impinging electromagnetic radiation upon a processing of the processing layer. The method furthermore comprises the step of iii) irradiating electromagnetic radiation onto the processing layer, as a result of which the processing layer is in a processed state. In other words, the irradiation of electromagnetic radiation onto the processing layer converts or transforms the processing layer in the processed state. The processing layer in the processed state comprises one or more reacted elements generated from the reactive elements. The processing layer in the processed state furthermore comprises one or more further reacted elements generated from one or more of the unreactive elements upon the interaction of the reactive elements with the impinging electromagnetic radiation, and furthermore comprises one or more unreactive elements remaining non-interacting. At least one personalization element is generated in the processing layer in the processed state, which personalization element comprises or consists of the non-interacting unreactive elements.

Any explanations made herein with regard to the data carrier or the security document or the method of producing the data carrier preferably likewise apply to the method of personalizing the data carrier and vice versa.

### BRIEF DESCRIPTION OF THE DRAWINGS

Preferred embodiments of the invention are described in the following with reference to the drawings, which are provided for the purpose of illustrating the present preferred embodiments of the invention and not for the purpose of limiting the same. In the drawings,
- Fig. 1: shows a top view of a data carrier comprising a personalization element according to the invention;
- Fig. 2: shows a schematic representation of a sectional view of a data carrier comprising a processing layer and a carrier body;
- Fig. 3: shows a schematic representation of another sectional view of a data carrier comprising a processing layer, a background layer and a carrier body;
- Fig. 4: shows a schematic representation of another sectional view of a data carrier comprising a processing layer, another background layer, and a carrier body;
- Fig. 5a: schematically shows a sectional view of a data carrier comprising a processing layer and a carrier body, wherein the processing layer is in an unprocessed state;
- Fig. 5b: schematically shows a sectional view of the data carrier according to figure 5a, wherein the processing layer is in a processed state;
- Fig. 6a: schematically shows another sectional view of a data carrier comprising a processing layer and a carrier body, wherein the processing layer is in an unprocessed state;
- Fig. 6b: schematically shows a sectional view of the data carrier according to figure 6a, wherein the processing layer is in a processed state;
- Fig. 7a: schematically shows another sectional view of a data carrier comprising a processing layer and a carrier body, wherein the processing layer is in an unprocessed state;
- Fig. 7b: schematically shows a sectional view of the data carrier according to figure 7a, wherein the processing layer is in a processed state;
- Fig. 8a: schematically shows another sectional view of a data carrier comprising a processing layer and a carrier body, wherein the processing layer is in an unprocessed state;
- Fig. 8b: schematically shows a sectional view of the data carrier according to figure 8a, wherein the processing layer is in a processed state;
- Fig. 9: shows a top partial view of a data carrier comprising a personalization element;
- Fig. 10: shows another top partial view of a data carrier comprising a personalization element according to the invention;
- Fig. 11: shows another top partial view of a data carrier comprising another personalization element according to the invention;
- Fig. 12: shows another top partial view of a data carrier comprising another personalization element according to the invention;
- Fig. 13: shows another top partial view of a data carrier comprising another personalization element according to the invention.

### DESCRIPTION OF PREFERRED EMBODIMENTS

With respect to the figures, various aspects of a data carrier 1 according to the invention will be discussed in greater detail.

The data carrier 1 according to the invention in each case comprises at least one carrier body 2 and at least one processing layer 3. The processing layer 3, at least in an unprocessed state of the processing layer 3, comprises one or more reactive elements 4 and one or more unreactive elements 5. The reactive elements 4 are configured to interact with impinging electromagnetic radiation R upon a processing of the processing layer. The processing layer 3, in a processed state of the processing layer 3, comprises one or more reacted elements 6 generated from the reactive elements 4. The processing layer 3 in the processed state furthermore comprises one or more further reacted elements 7 being generated from one or more of the unreactive elements 5 upon the interaction of the reactive elements 4 with the impinging electromagnetic radiation R and furthermore comprises one or more unreactive elements 5 remaining non-interacting. The processing layer 3 in the processed state furthermore comprises at least one personalization element 100, which personalization element 100 comprises or consists of the non-interacting unreactive elements 8.

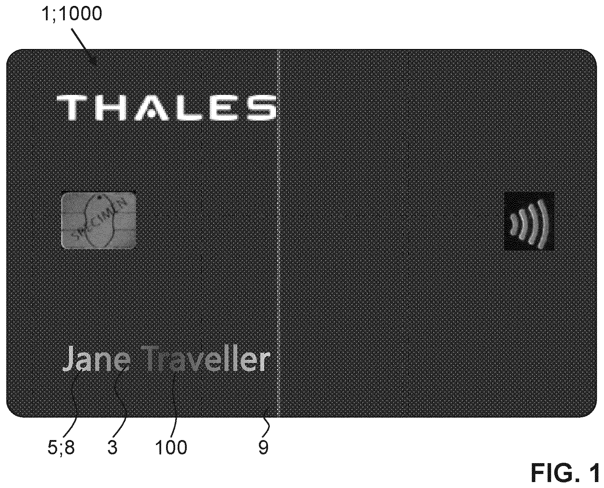

The data carrier 1 depicted in figure 1 is a banking card, wherein the personalization element 100 corresponds here to the name of the holder of the banking card, i.e. to the alphanumeric character "Jane Traveller". That is, the data carrier 1 corresponds here to a security document 1000. The data carrier 1 comprises further elements as they are common in the banking card industry, e.g. here an EMV chip that allows payments. The personalization element 100 exhibits a changing appearance that changes with respect to a transverse direction T of the data carrier 1. The transverse direction T can be seen as a horizontal direction running parallel to a surface of the data carrier 1 and within a horizontal plane. The extension direction E can be seen as a vertical direction running perpendicularly to the horizontal direction and within a vertical plane being perpendicular to the horizontal plane. In the depicted example, the changing appearance corresponds to a chromatic colour gradient.

At this point, it should be noted that a changing appearance or a changing colour etc., might not be clearly visible in the depicted figures because both the schematic pictures and photographic images had to be converted into black and white images.

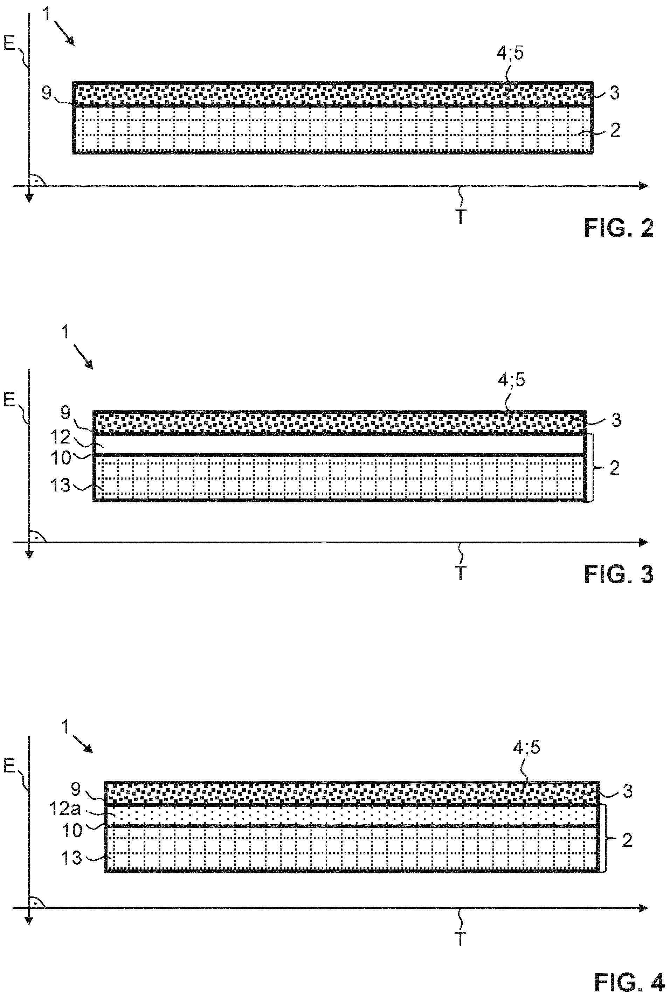

As can be seen in figures 2 to 4, the carrier body 2 comprises a top surface 9, and wherein the processing layer 3 is arranged on the top surface 9 of the carrier body 2. In other words, when seen along the extension direction E extending perpendicularly to the transverse direction T, the processing layer 3 is arranged before the carrier body 2. Furthermore, the processing layer 3 is here a print, in particular a surface print being printed onto a surface of the carrier body 2. In the depicted examples, the processing layer 3 corresponds to a CMYK printed layer. CMYK refers to the four primary coloured components used as one of the conventional colour printing schemes: Cyan, Magenta, Yellow and Key (blacK).

The examples of data carriers 1 of figures 2 to 4 differ in the configuration of their carrier bodies. In fact, the carrier body 2 of the data carrier 1 depicted in figure 2 schematically represents any conventional document body, consisting of or comprising transparent and non-transparent plastic layers and comprising a top surface suitable for adding a surface print. The carrier body 2 of figure 3 consists of the conventional document body as well as an additional background layer 12, which background layer 12 corresponds here to a white surface print that is printed onto a top surface 10 of the uppermost transparent plastic layer 13. However, it should be noted that said uppermost plastic layer need not be transparent. In this example the processing layer 3 is printed onto a top surface 9 of the background layer 12. The carrier body 2 of figure 4 particularly comprises a background layer 12a located within the conventional document body, which background layer 12a corresponds here to a laser-engravable plastic layer. Also in this case the background layer 12a is arranged on a top surface 10 of the uppermost transparent plastic layer 13, and wherein the processing layer 3 in turn is arranged on a top surface 9 of the laser-engravable background layer 12a. That is to say, the background layer 12, 12a is in each case arranged after the processing layer 3 with respect to the extension direction E. It should be noted that the carrier body 2 can comprise further layers as they are known in the art, for example several background layers, metallic foils, etc. To this end it should be noted that the data carrier may also comprise a metal layer (such as aluminum foil), a metal core (steel or other different alloys or metals), a wooden core, or even be mostly made of a metal and have practically no plastic layers. In fact, the composition of the carrier body 2 is not crucial as long as it does not participate in the personalization processing according to the invention. Furthermore, in the depicted examples the processing layer 3 as well as the layers constituting the carrier body 2 are continuous layers with respect to the extension direction E and the transverse direction T. That is, the layers do not comprise any interruptions nor are they arranged in sections. However, interruptions are likewise conceivable.

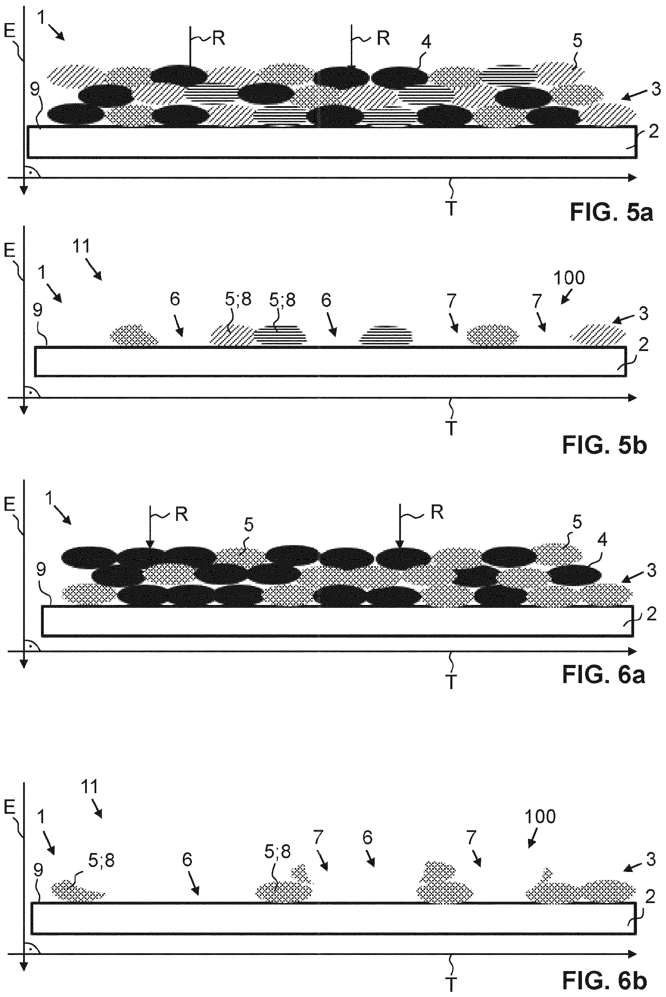

With respect to figures 5a to 8b, various arrangements of the data carrier 1 will be explained that result in the personalization element 100 of varying appearance according to the invention.

At least in the unprocessed state of the processing layer 3 each data carrier 1 comprises a processing layer 3 in the form of a CMYK multi-colour surface print, see figures 5a, 6a, 7a and 8a. These figures depict a preferred embodiment, wherein the radiation source preferably is a 1064 nanometer NIR laser, although other embodiments and other radiation sources are likewise conceivable. The different CMYK-coloured printed elements are visualized by different filling patterns, wherein an entirely black pattern is used to designate black or the Key, a pattern of horizontal lines is used to designate Cyan, a pattern of diagonal lines is used to designate Yellow, and a cross-line pattern is used to designate Magenta, respectively. Hence, the reactive elements 4 of the processing layer 3 are provided here by means of the black or Key ink (printed elements), comprising a near-infrared absorbing black pigment and thus sensitive to the electromagnetic radiation of the near-infrared personalization laser source. Moreover, the unreactive elements 5 of the processing layer 3 are provided here by non-radiation-sensitive or non-radiation-absorbing or non-radiation-scattering inks with regard to the same near-infrared personalization laser source.

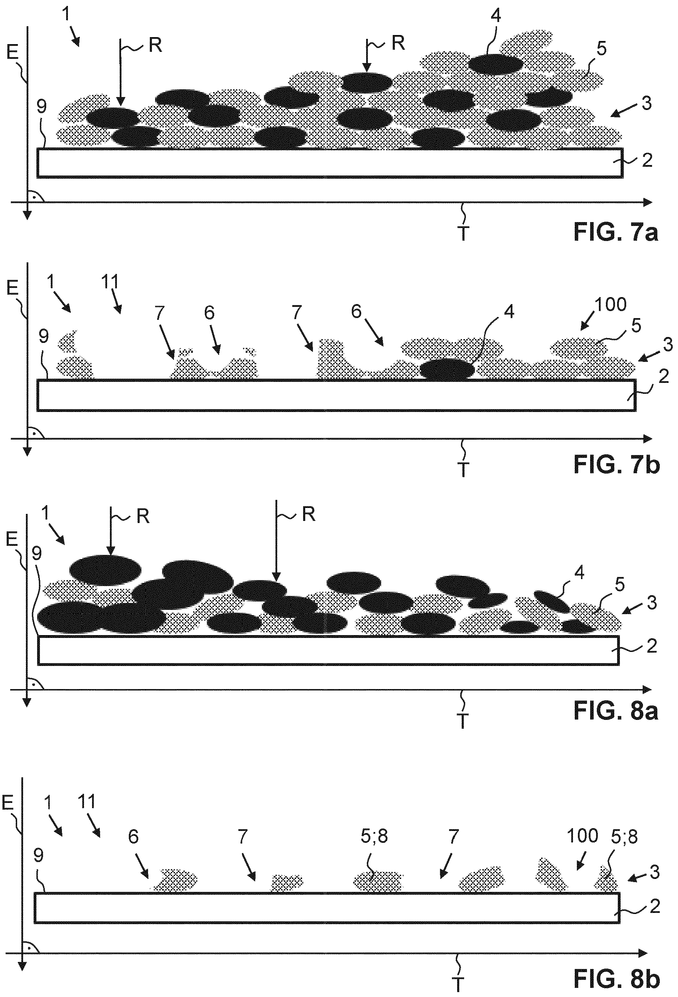

As becomes apparent from a comparison of figures 5a, 6a, 7a and 8a with figures 5b, 6b, 7b and 8b depicting the processing layer 3 in the processed state, the irradiation of electromagnetic radiation R onto the processing layer 3 generates reacted elements 6 from the reactive elements 4, and further reacted elements 7 from the unreactive elements 5, while some of the unreactive elements 5 remain unaffected. These remaining unreactive elements 5 correspond to the non-interacting unreactive elements 8 mentioned above. Here, the reacted elements 6 and the further reacted elements 7 are ablated elements or evaporated elements, i.e. elements of removed material, so that holes or recesses are formed in the processed processing layer 3. Since the processing layer 3 is arranged on a surface 9 of the carrier body 2, the elements of removed material 6, 7 generate a relief structure 11 in the processing layer 3. In other words, the processed processing layer 3 exhibits a tactile effect. In figures 6b and 8b, the relief structure 11 is provided by the non-interacting unreactive elements 8. In figure 7b, the relief structure 11 is provided by the non-interacting unreactive elements 8 and the reactive element 4. In all depicted examples, the processing layer 3 in its unprocessed state exhibits a first appearance and in its processed state exhibits a second appearance, wherein the first appearance and the second appearance differ from one another. In addition, the reactive elements 4, the unreactive elements 5, the non-interacting unreactive elements 8, the reacted elements 6 and the further reacted elements 7 are irregularly distributed in the processing layer 3 with respect to the extension direction E and the transverse direction T.

The processing layers 3 of figures 5a to 8b differ in the amount or density or concentration, the arrangement and the spacing between neighbouring elements. In fact, figure 5a depicts a data carrier 1 comprising a processing layer 3 in the unprocessed state of cyan, black, yellow and magenta elements 5. Upon the processing of the processing layer 3, all black elements 4 and a majority of the CMY elements 5 are removed, see figure 5b depicting the processing layer 3 in its processed state. The personalization element 100 consisting of said processing layer 3 has an appearance being provided by the remaining CMY elements 8 of the processed processing layer 3 and the appearance by the carrier body 2. To this end, the colour and arrangement of the individual coloured elements 8 is such that the personalization element 100 exhibits a "rainbow" or colour-variable appearance. Figure 6a depicts an unprocessed processing layer 3 that consists of black elements 4 and magenta elements 5 only. Furthermore, the magenta elements 5 as well as the black elements 4 are in each case arranged in a gradient. In fact, the amount or density or concentration and the spacing between neighbouring black elements 4 changes with respect to the extension direction E and the transverse direction T, with the amount or density or concentration being higher in the depicted left side of the data carrier 1 as compared to the depicted right side of the data carrier 1. The magenta elements 5 exhibit a reversed gradient, i.e. the amount or density or concentration of the magenta elements 5 in the depicted left side of the data carrier 1 is lower as compared to the depicted right side of the data carrier 1. In the processing of the processing layer 3, all black elements 4 are removed. As a consequence, the processed processing layer 3 consists of magenta elements 8 only, wherein said magenta elements 8 are still provided in a gradient.

Figure 7a depicts an unprocessed processing layer 3 consisting of black elements 4 and magenta elements 5, wherein the magenta elements 5 are again provided in a gradient, but wherein the black elements 4 are arranged uniformly, i.e. with an unchanging number or density. As follows from a comparison between figures 6a and 7a, a thickness of the processing layer 3 with respect to the extension direction E varies with respect to the transverse direction T. That is, the processing layer 3 in the depicted right side of the data carrier 1 is thicker than in the depicted left side of the data carrier 1. Said varying thickness is provided here by the particular gradient of the magenta elements 5. Upon the processing of the processing layer 3 a processed processing layer 3 is generated, which comprises magenta elements 8 being again provided in a gradient.

Figure 8a depicts a processing layer 3 consisting of black elements 4 and magenta elements 5, wherein the black elements 4 are provided in a gradient and wherein the magenta elements 5 correspond to a uniform coverage. Here, the gradient in the black elements 4 is provided only via a varying size of the black elements 4, while the concentration of the black elements per unit surface is maintained constant. That is, black elements 4 being arranged in the depicted left side of the data carrier 1 are larger than the black elements 4 being arranged in the depicted right side of the data carrier 1. Both the size and the concentration per unit surface of the magenta elements 5 however are constant. The different sizes of the black elements 4 are achieved here by using three different droplet volumes of black ink in the inkjet printer. The constant size of the magenta elements 5 in turn is achieved by using a constant droplet volume in the printing process. As follows from figure 8b, the processing of said processing layer 3 results in a processed processing layer 3 consisting of magenta elements 8, which are arranged in a gradient. Furthermore, said processed processing layer 3 comprises a gradient of magenta colour 8 that is finer-resolved than that of the previously discussed processing layers 3 and that can be comparable to obtaining higher-resolution halftone "grid" known for conventional prints.

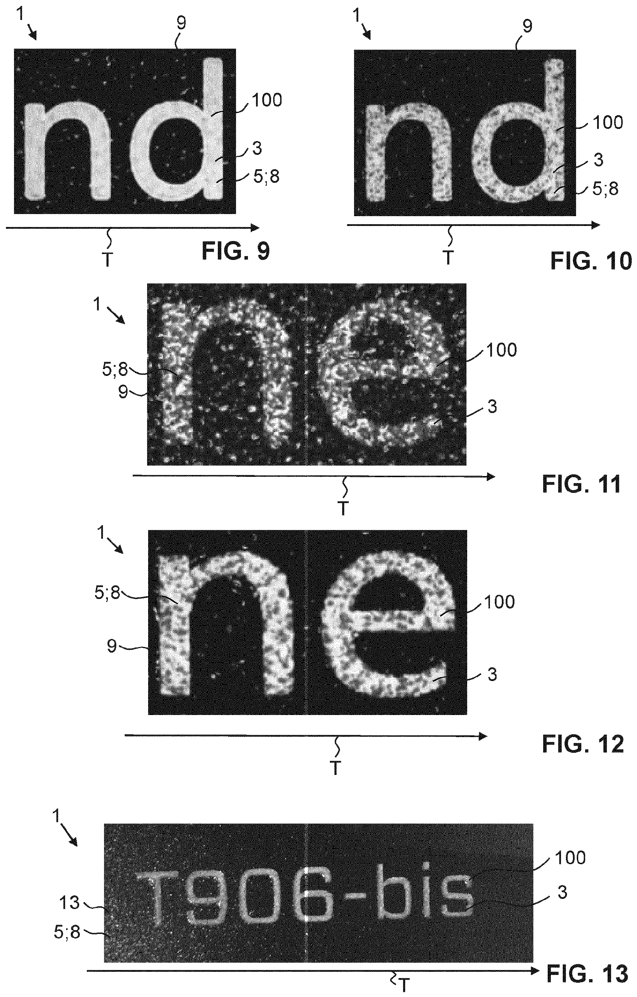

The invention shall be further illustrated by figures 9 to 13, which depict partial photographs of data carriers 1 comprising various personalization elements 100 according to the invention. In the depicted examples, the personalization elements 100 again correspond to alphanumeric characters. These personalization elements 100 were in each case produced by applying a processing layer 3 as a standard mode inkjet printing (using a commercial inkjet printer) on the surface 9 of a white background layer 12 (figures 9 to 12) or on the surface of a transparent laser-engravable plastic layer 13 (figure 13), wherein the amounts of the inkjet-printed coloured inks were specified manually, as expressed in percentages of TAC - total area coverage (figures 9, 11-12) or were defined by a printer-controlled algorithm for a selected ICC profile as it is known in the art (figure 10). The colour drop distribution and the printing sequence in each case were used as determined by default by the printer software and are also hardware-dependent (e.g. depend on the physical configuration of the printing heads etc).

The different personalization element 100 differ here in the ink percentage ratio between the reactive elements 4, here printed with the black ink, and the unreactive elements 5, here printed with other (CMY) inks, and their predetermined surface coverage values. In fact, figure 9 depicts a part of the processed processing layer 3, wherein the personalization element 100 "nd" was generated from an unprocessed processing layer 3 consisting of the black ink only (black elements 4) with 100 % total surface coverage according to a manual setup. In figure 9, the processing layer 3 does not comprise any unreactive elements, only reactive ones, namely 100% black ink and thus no variable appearance. Figure 9 is provided for illustrative purposes, in fact for illustrating a variable appearance, which becomes readily apparent when figure 9 is compared to figure 10 where the both elements are present, and there is a coloured appearance

That is, figure 10 depicts a part of the processed processing layer 3, wherein the personalization element 100 "nd" was generated from an unprocessed layer, wherein the said unprocessed processing layer represented a 100% "Pantone Black C" print, with printer-defined coverages by individual inks according to the ICC profile of the printer. In the described case, the "100% Pantone Black C" print comprised Black printed elements 4 along with other coloured inks 5. Figure 11 depicts a part of the processed processing layer 3, wherein the personalization element 100 "ne" was generated from an unprocessed processing layer 3 comprising 50 % coverage in black ink (black elements 4) and 100 % coverage in magenta ink (other coloured elements 5) with manual input. Figure 12 depicts a part of the processed processing layer 3, wherein the personalization element 100 "ne" was generated from an unprocessed processing layer 3 comprising 100 % coverage in black ink (black elements 4) and 100 % coverage in magenta ink (other coloured elements 5), with manual input. Hence, as is seen from these figures, the level of randomly distributed black ink 4 defines a sort of post-print halftoning of the other present colour(s) 5 *via* laser ablation. If targeting a certain colour of the personalization element 100 and its particular level of brightness/saturation, correspondingly selected levels of this colour 5 and of black 4 can be pre-printed.

Figure 13 depicts another example of a personalization element 100, wherein said personalization element 100 exhibits a colour gradient as well. In fact, the personalization element 100 combines both a chromatic colour gradient and a black gradient. In this example, the unprocessed processing layer 3 was printed on a transparent laser-engravable background layer 12a. Furthermore, two different types of laser marking are present in the same personalized element, as the white background colour is generated via conventional foaming-type marking in the said laser-engravable PVC layer 12a.

It should be noted that the size of the personalization elements 100 can be fine enough such as 300-500 µm or smaller to fulfil criteria of "microtext" or other small-scale security elements. Regarding a size of the depicted photographed personalization elements, it is noted that the relative proportion on surface of the data carrier corresponds to the representation in Figure 1 - and quantitatively the laser marking was made as the text types 5 to 8, which corresponds to the letter heights being approximately between 2.5 to 4 mm.

In addition, the creation of different type of patterns is also possible. For instance, instead of the CMYK inks, other kinds of inks such as fluorescent inks can be used, for instance for generating multiple-colour fluorescent personalization elements. It is also conceivable to use functional prints or coatings, etc.

### LIST OF REFERENCE SIGNS

| | | | |
|---|---|---|---|
| 1 | data carrier | 11 | relief structure |
| 2 | carrier body | 12, 12a | background layer |
| 3 | processing layer | 13 | plastic layer |
| 4 | reactive element | | |
| 5 | unreactive element | 100 | personalization element |
| 6 | reacted element | 1000 | security document |
| 7 | further reacted element | | |
| 8 | non-interacting unreactive element | E | extension direction |
| | | T | transverse direction |
| 9 | top surface | R | electromagnetic radiation |
| 10 | top surface | | |

## Claims

1. A data carrier (1) extending along an extension direction (E) and comprising:
- at least one carrier body (2); and
- at least one processing layer (3),
wherein the processing layer (3), at least in an unprocessed state of the processing layer (3), comprises one or more reactive elements (4) and one or more unreactive elements (5),
wherein the reactive elements (4) are configured to interact with impinging electromagnetic radiation (R) upon a processing of the processing layer (3),
wherein the processing layer (3), in a processed state of the processing layer (3), comprises one or more reacted elements (6) being generated from the reactive elements (4),
wherein the processing layer (3) in the processed state furthermore comprises one or more further reacted elements (7) being generated from one or more of the unreactive elements (5) upon the interaction of the reactive elements (4) with the impinging electromagnetic radiation (R) and furthermore comprises one or more unreactive elements (5) remaining non-interacting, and
wherein the processing layer (3) in the processed state furthermore comprises at least one personalization element (100), which personalization element (100) comprises or consists of the non-interacting unreactive elements (8),
**characterized in that** the reactive elements (4) and/or the unreactive elements (5) are provided in a gradient with respect to the extension direction (E) and/or with respect to a transverse direction (T) extending perpendicularly to the extension direction (E).

2. The data carrier (1) according to claim 1, wherein the processing layer (3) in its unprocessed state exhibits a first appearance and in its processed state exhibits a second appearance, the first appearance and the second appearance differing from one another.

3. The data carrier (1) according to any one of the preceding claims,
wherein one or more unreactive elements (5) are of a first appearance and at least one or more further unreactive elements are of at least a further appearance, the first appearance and further appearance differing from one another.

4. The data carrier (1) according to any one of the preceding claims,
wherein one or more non-interacting unreactive elements (8) are of a first appearance and at least one or more further non-interacting unreactive elements (8) are of at least a further appearance, the first appearance and further appearance differing from one another.

5. The data carrier (1) according to any one of the preceding claims, wherein the reactive elements (4) and/or the unreactive elements (5) are regularly or irregularly distributed in the processing layer (3).

6. The data carrier (1) according to any one of the preceding claims, wherein at least one of the non-interacting unreactive elements (8), the reacted elements (6), and the further reacted elements (7) are regularly or irregularly distributed in the processing layer (3).

7. The data carrier (1) according to any one of the preceding claims, wherein the non-interacting unreactive elements (8) and/or the reacted elements (6) and/or the further reacted elements (7) are provided in a gradient with respect to the extension direction (E) and/or with respect to a transverse direction (T) extending perpendicularly to the extension direction (E).

8. The data carrier (1) according to any one of claims 1 to 6, wherein at least one of the reactive elements (4), the unreactive elements (5), the non-interacting unreactive elements (8), the reacted elements (6) and the further reacted elements (7) are uniformly distributed with respect to the extension direction (E) and/or with respect to a transverse direction (T) extending perpendicularly to the extension direction (E).

9. The data carrier (1) according to any one of the preceding claims, wherein the reactive elements (4) are provided in a gradient and the unreactive elements (5) are uniformly distributed with respect to the extension direction (E) and/or a transverse direction (T) running perpendicularly with respect to the extension direction (E).

10. The data carrier (1) according to any one of claims 1 to 8, wherein the unreactive elements (5) are provided in a gradient and the reactive elements (4) are uniformly distributed with respect to the extension direction (E) and/or a transverse direction (T) running perpendicularly with respect to the extension direction (E).

11. The data carrier (1) according to any one of the preceding claims, wherein in the unprocessed state of the processing layer (3) the amount of unreactive elements (5) equals or is different from the amount of reactive elements (4).

12. The data carrier (1) according to any one of the preceding claims, wherein in the unprocessed state of the processing layer (3) the amount of reactive elements (4) represents at least 10 % or more, preferably at least 20 % or more, particularly preferably at least 25 % or more, of the total amount of reactive elements (4) and unreactive elements (5).

13. The data carrier (1) according to any one of the preceding claims, wherein the carrier body (2) comprises a top surface (9), and wherein the processing layer (3) is arranged on the top surface (9) of the carrier body (2).

14. The data carrier (1) according to any one of the preceding claims, wherein the personalization element (100) comprises a relief structure (11), the relief structure (11) being preferably provided by the non-interacting unreactive elements (8) and possibly furthermore by the reactive elements (4) and/or the reacted elements (6) and/or the further reacted elements (7).

15. The data carrier (1) according to any one of the preceding claims,
wherein the relief structure (11) is provided in a gradient with respect to the extension direction (E) and/or with respect to a transverse direction (T) extending perpendicularly to the extension direction (E).

16. The data carrier (1) according to any one of the preceding claims, wherein the processing layer (3) is a print, preferably a multi-appearance print such as a multi-colour print.

17. The data carrier (1) according to any one of the preceding claims,
wherein the reactive element (4) is radiation-sensitive and/or radiation-absorbing and/or radiation-scattering and/or provided as an ink and/or comprises a radiation-reactive pigment and/or a reactive additive and/or a reactive colorant.

18. The data carrier (1) according to any one of the preceding claims, wherein the unreactive element (5) is non-radiation-sensitive and/or non-radiation absorbing and/or non-radiation-scattering and/or provided as an ink, preferably inkjet print ink and/or screen-printing ink and/or representing a special effect ink such thermochromic ink and/or photochromic ink, and/or luminescent ink and the like.

19. The data carrier (1) according to any one of the preceding claims, wherein the reacted element (6) and/or the further reacted element (7) is a bleached element and/or an ablated element and/or an evaporated element and/or a colour-changed element and/or an opaque element and/or a bubbling element and/or a bulging element and/or a blurry element and/or a fuzzy element.

20. The data carrier (1) according to any one of the preceding claims, wherein a size of at least one of the unreactive elements (5), the reactive elements (4), the non-interacting unreactive elements (8), the reacted elements (6) and the further reacted elements (7) is in the range of 30 micrometers to 1000 micrometers, preferably in the range of 150 micrometer to 500 micrometer.

21. The data carrier (1) according to any one of the preceding claims, wherein a size of at least one of the unreactive elements (5), the reactive elements (4), the non-interacting unreactive elements (8), the reacted elements (6) and the further reacted elements (7) is 30 micrometer or more, preferably 150 micrometer or more.

22. The data carrier (1) according to any one of the preceding claims, wherein the processing layer (3) is continuous or intermittent with respect to the extension direction (E) and/or with respect to a transverse direction (T) running perpendicularly to the extension direction (E).

23. The data carrier (1) according to any one of the preceding claims, further comprising at least one background layer (12, 12a), wherein the background layer (12, 12a) is arranged after the processing layer (3) with respect to the extension direction (E), the background layer (12, 12a) being configured to reflect and/or scatter and/or absorb impinging electromagnetic radiation (R).

24. The data carrier (1) according to any one of the preceding claims,
wherein the background layer (12, 12a) is non-transparent or transparent and/or a laser-markable layer and/or comprises at least one metallic compound such as a preferably thin flexible metal foil or a preferably thicker rigid metal layer.

25. A security document (1000) comprising or consisting of at least one data carrier (1) as claimed in any one of the preceding claims, the security document preferably being a banking card, an identity card, a passport, a smart card, a driving licence, a data page or the like.

26. A method of producing a data carrier (1), preferably a data carrier as claimed in any one of the preceding claims, the method comprising the steps of:
- Providing at least one carrier body (2); and
- Providing at least one processing layer (3),
wherein the processing layer (3), at least in an unprocessed state of the processing layer (3), comprises one or more reactive elements (4) and one or more unreactive elements (5),
wherein the reactive elements (4) are configured to interact with impinging electromagnetic radiation (R) upon a processing of the processing layer (3),
wherein the processing layer (3), in a processed state of the processing layer (3), comprises one or more reacted elements (6) being generated from the reactive elements (4),
wherein the processing layer (3) in the processed state furthermore comprises one or more further reacted elements (7) being generated from one or more of the unreactive elements (5) upon the interaction of the reactive elements (4) with the impinging electromagnetic radiation (R) and furthermore comprises one or more unreactive elements (5) remaining non-interacting, and
wherein the processing layer (3) in the processed state furthermore comprises at least one personalization element (100), which personalization element (100) comprises or consists of the non-interacting unreactive elements (8),
**characterized in that**
the reactive elements (4) and/or the unreactive elements (5) are provided in a gradient with respect to the extension direction (E) and/or with respect to a transverse direction (T) extending perpendicularly to the extension direction (E).

27. A method of personalizing a data carrier (1), preferably a data carrier as claimed in any one of claims 1 to 25, the method comprising the steps of:
- Providing at least one carrier body (2); and
- Providing at least one processing layer (3),
wherein the processing layer (3), at least in an unprocessed state of the processing layer (3), comprises one or more reactive elements (4) and one or more unreactive elements (5), and
wherein the reactive elements (4) are configured to interact with impinging electromagnetic radiation (R) upon a processing of the processing layer (3),
wherein the method furthermore comprises the step of:
- Irradiating electromagnetic radiation (R) onto the processing layer (3), whereby the processing layer (3) is in a processed state,
wherein the processing layer (3) in the processed state comprises one or more reacted elements (6) being generated from the reactive elements (4),
wherein the processing layer (3) in the processed state furthermore comprises one or more further reacted elements (7) being generated from one or more of the unreactive elements (5) upon the interaction of the reactive elements (4) with the impinging electromagnetic radiation (R) and furthermore comprises one or more unreactive elements (5) remaining non-interacting, and
wherein at least one personalization element (100) is generated in the processing layer (3) in the processed state, which personalization element (100) comprises or consists of the non-interacting unreactive elements (8),
**characterized in that** the reactive elements (4) and/or the unreactive elements (5) are provided in a gradient with respect to the extension direction (E) and/or with respect to a transverse direction (T) extending perpendicularly to the extension direction (E).

## Patentansprüche

1. Datenträger (1), der sich entlang einer Erstreckungsrichtung (E) erstreckt und Folgendes umfasst:
- mindestens einen Trägerkörper (2); und
- mindestens eine Verarbeitungsschicht (3),
wobei die Verarbeitungsschicht (3) mindestens in einem unverarbeiteten Zustand der Verarbeitungsschicht (3) ein oder mehrere reaktive Elemente (4) und ein oder mehrere nicht reaktive Elemente (5) umfasst,
wobei die reaktiven Elemente (4) konfiguriert sind, um bei einer Verarbeitung der Verarbeitungsschicht (3) mit auftreffender elektromagnetischer Strahlung (R) zu interagieren,
wobei die Verarbeitungsschicht (3) in einem verarbeiteten Zustand der Verarbeitungsschicht (3) ein oder mehrere reagierte Elemente (6) umfasst, die aus den reaktiven Elementen (4) erzeugt werden,
wobei die Verarbeitungsschicht (3) in dem verarbeiteten Zustand ferner ein oder mehrere weitere reagierte Elemente (7) umfasst, die aus einem oder mehreren der nicht reaktiven Elemente (5) bei der Interaktion der reaktiven Elemente (4) mit der auftreffenden elektromagnetischen Strahlung (R) erzeugt werden, und ferner ein oder mehrere nicht reaktive Elemente (5) umfasst, die nicht interagieren, und
wobei die Verarbeitungsschicht (3) in dem verarbeiteten Zustand ferner mindestens ein Personalisierungselement (100) umfasst, wobei das Personalisierungselement (100) nicht interagierende, nicht reaktive Elemente (8) umfasst oder daraus besteht,
**dadurch gekennzeichnet, dass**
die reaktiven Elemente (4) und/oder die nicht reaktiven Elemente (5) in einem Gradienten bezüglich der Erstreckungsrichtung (E) und/oder bezüglich einer senkrecht zur Erstreckungsrichtung (E) verlaufenden Querrichtung (T) bereitgestellt sind.

2. Datenträger (1) nach Anspruch 1, wobei die Verarbeitungsschicht (3) in ihrem unverarbeiteten Zustand ein erstes Erscheinungsbild und in ihrem verarbeiteten Zustand ein zweites Erscheinungsbild aufweist, wobei sich das erste Erscheinungsbild und das zweite Erscheinungsbild voneinander unterscheiden.

3. Datenträger (1) nach einem der vorstehenden Ansprüche,
wobei ein oder mehrere nicht reaktive Elemente (5) eine erste Erscheinungsform aufweisen und mindestens ein oder mehrere weitere nicht reaktive Elemente mindestens eine weitere Erscheinungsform aufweisen, wobei sich die erste Erscheinungsform und die weitere Erscheinungsform voneinander unterscheiden.

4. Datenträger (1) nach einem der vorstehenden Ansprüche,
wobei ein oder mehrere nicht interagierende, nicht reaktive Elemente (8) eine erste Erscheinungsform aufweisen und mindestens ein oder mehrere weitere nicht interagierende, nicht reaktive Elemente (8) mindestens eine weitere Erscheinungsform aufweisen, wobei sich die erste Erscheinungsform und die weitere Erscheinungsform voneinander unterscheiden.

5. Datenträger (1) nach einem der vorstehenden Ansprüche, wobei die reaktiven Elemente (4) und/oder die nicht reaktiven Elemente (5) regelmäßig oder unregelmäßig in der Verarbeitungsschicht (3) verteilt sind.

6. Datenträger (1) nach einem der vorstehenden Ansprüche, wobei mindestens eines der nicht interagierenden, nicht reaktiven Elemente (8), der reagierten Elemente (6) und der weiteren reagierten Elemente (7) regelmäßig oder unregelmäßig in der Verarbeitungsschicht (3) verteilt ist.

7. Datenträger (1) nach einem der vorstehenden Ansprüche, wobei die nicht interagierenden nicht-reaktiven Elemente (8) und/oder die reagierten Elemente (6) und/oder die weiteren reagierten Elemente (7) in einem Gradienten bezüglich der Erstreckungsrichtung (E) und/oder bezüglich einer senkrecht zur Erstreckungsrichtung (E) verlaufenden Querrichtung (T) bereitgestellt sind.

8. Datenträger (1) nach einem der Ansprüche 1 bis 6, wobei mindestens eines der reaktiven Elemente (4), der nicht reaktiven Elemente (5), der nicht interagierenden, nicht reaktiven Elemente (8), der reagierten Elemente (6) und der weiteren reagierten Elemente (7) bezügliche der Erstreckungsrichtung (E) und/oder bezüglich einer senkrecht zur Erstreckungsrichtung (E) verlaufenden Querrichtung (T) gleichmäßig verteilt ist.

9. Datenträger (1) nach einem der vorstehenden Ansprüche, wobei die reaktiven Elemente (4) in einem Gradienten bereitgestellt sind und die nicht reaktiven Elemente (5) bezüglich der Erstreckungsrichtung (E) und/oder einer senkrecht zur Erstreckungsrichtung (E) verlaufenden Querrichtung (T) gleichmäßig verteilt sind.

10. Datenträger (1) nach einem der Ansprüche 1 bis 8, wobei die nicht reaktiven Elemente (5) in einem Gradienten bereitgestellt sind und die reaktiven Elemente (4) bezüglich der Erstreckungsrichtung (E) und/oder einer senkrecht zur Erstreckungsrichtung (E) verlaufenden Querrichtung (T) gleichmäßig verteilt sind.

11. Datenträger (1) nach einem der vorstehenden Ansprüche, wobei in dem unverarbeiteten Zustand der Bearbeitungsschicht (3) die Menge der nicht reaktiven Elemente (5) gleich der Menge der reaktiven Elemente (4) ist oder sich von dieser unterscheidet.

12. Datenträger (1) nach einem der vorstehenden Ansprüche, wobei in dem unverarbeiteten Zustand der Verarbeitungsschicht (3) die Menge der reaktiven Elemente (4) mindestens 10 % oder mehr, vorzugsweise mindestens 20 % oder mehr, besonders bevorzugt mindestens 25 % oder mehr, der Gesamtmenge der reaktiven Elemente (4) und nicht reaktiven Elemente (5) beträgt.

13. Datenträger (1) nach einem der vorstehenden Ansprüche, wobei der Trägerkörper (2) eine Oberseite (9) umfasst, und wobei die Verarbeitungsschicht (3) auf der Oberseite (9) des Trägerkörpers (2) angeordnet ist.

14. Datenträger (1) nach einem der vorstehenden Ansprüche, wobei das Personalisierungselement (100) eine Reliefstruktur (11) umfasst, wobei die Reliefstruktur (11) vorzugsweise durch die nicht interagierenden, nicht reaktiven Elemente (8) und möglicherweise ferner durch die reaktiven Elemente (4) und/oder die reagierten Elemente (6) und/oder die weiteren reagierten Elemente (7) bereitgestellt wird.

15. Datenträger (1) nach einem der vorstehenden Ansprüche,
wobei die Reliefstruktur (11) bezüglich der Erstreckungsrichtung (E) und/oder bezüglich einer senkrecht zur Erstreckungsrichtung (E) verlaufenden Querrichtung (T) in einem Gradienten bereitgestellt ist.

16. Datenträger (1) nach einem der vorstehenden Ansprüche, wobei die Verarbeitungsschicht (3) ein Druck ist, vorzugsweise ein Multi-Design-Druck, beispielsweise ein Mehrfarbendruck.

17. Datenträger (1) nach einem der vorstehenden Ansprüche,
wobei das reaktive Element (4) strahlungsempfindlich und/oder strahlungsabsorbierend und/oder strahlungsstreuend ist und/oder als Tinte bereitgestellt ist und/oder ein strahlungsreaktives Pigment und/oder einen reaktiven Zusatzstoff und/oder einen reaktiven Farbstoff umfasst.

18. Datenträger (1) nach einem der vorstehenden Ansprüche, wobei das nicht reaktive Element (5) nicht strahlungsempfindlich und/oder nicht strahlungsabsorbierend und/oder nicht strahlungsstreuend ist und/oder als Tinte, vorzugsweise Tintenstrahldrucktinte und/oder Siebdrucktinte, bereitgestellt ist und/oder eine Spezialeffekttinte, wie thermochrome Tinte und/oder photochrome Tinte, und/oder lumineszierende Tinte und dergleichen darstellt.

19. Datenträger (1) nach einem der vorstehenden Ansprüche, wobei das reagierte Element (6) und/oder das weitere reagierte Element (7) ein gebleichtes Element und/oder ein abgetragenes Element und/oder ein verdampftes Element und/oder ein farbverändertes Element und/oder ein opakes Element und/oder ein blasenbildendes Element und/oder ein wulstiges Element und/oder ein verschwommenes Element und/oder ein unscharfes Element ist.

20. Datenträger (1) nach einem der vorstehenden Ansprüche, wobei eine Größe von mindestens einem der nicht reaktiven Elemente (5), der reaktiven Elemente (4), der nicht interagierenden, nicht reaktiven Elemente (8), der reagierten Elemente (6) und der weiteren reagierten Elemente (7) in dem Bereich von 30 Mikrometern bis 1000 Mikrometern, vorzugsweise in dem Bereich von 150 Mikrometern bis 500 Mikrometern liegt.

21. Datenträger (1) nach einem der vorstehenden Ansprüche, wobei eine Größe von mindestens einem der nicht reaktiven Elemente (5), der reaktiven Elemente (4), der nicht interagierenden, nicht reaktiven Elemente (8), der reagierten Elemente (6) und der weiteren reagierten Elemente (7) 30 Mikrometer oder mehr, vorzugsweise 150 Mikrometer oder mehr beträgt.

22. Datenträger (1) nach einem der vorstehenden Ansprüche, wobei die Verarbeitungsschicht (3) bezüglich der Erstreckungsrichtung (E) und/oder bezüglich einer senkrecht zur Erstreckungsrichtung (E) verlaufenden Querrichtung (T) durchgehend oder unterbrochen ist.

23. Datenträger (1) nach einem der vorstehenden Ansprüche, ferner umfassend mindestens eine Hintergrundschicht (12, 12a), wobei die Hintergrundschicht (12, 12a) bezüglich der Erstreckungsrichtung (E) nach der Verarbeitungsschicht (3) angeordnet ist, wobei die Hintergrundschicht (12, 12a) konfiguriert ist, um auftreffende elektromagnetische Strahlung (R) zu reflektieren und/oder zu streuen und/oder zu absorbieren.

24. Datenträger (1) nach einem der vorstehenden Ansprüche,
wobei die Hintergrundschicht (12, 12a) undurchsichtig oder durchsichtig ist und/oder eine lasermarkierbare Schicht ist und/oder mindestens eine metallische Verbindung wie eine vorzugsweise dünne flexible Metallfolie oder eine vorzugsweise dickere starre Metallschicht umfasst.

25. Sicherheitsdokument (1000), das mindestens einen Datenträger (1) nach einem der vorstehenden Ansprüche umfasst oder daraus besteht, wobei das Sicherheitsdokument vorzugsweise eine Bankkarte, ein Personalausweis, ein Reisepass, eine Smartcard, ein Führerschein, eine Datenseite oder dergleichen ist.

26. Verfahren zum Herstellen eines Datenträgers (1), vorzugsweise eines Datenträgers nach einem der vorstehenden Ansprüche, wobei das Verfahren die folgenden Schritte umfasst:
- Bereitstellen von mindestens einem Trägerkörper (2); und
- Bereitstellen von mindestens einer Verarbeitungsschicht (3),
wobei die Verarbeitungsschicht (3) mindestens in einem unverarbeiteten Zustand der Verarbeitungsschicht (3) ein oder mehrere reaktive Elemente (4) und ein oder mehrere nicht reaktive Elemente (5) umfasst,
wobei die reaktiven Elemente (4) konfiguriert sind, um bei einer Verarbeitung der Verarbeitungsschicht (3) mit auftreffender elektromagnetischer Strahlung (R) zu interagieren,
wobei die Verarbeitungsschicht (3) in einem verarbeiteten Zustand der Verarbeitungsschicht (3) ein oder mehrere reagierte Elemente (6) umfasst, die aus den reaktiven Elementen (4) erzeugt werden,
wobei die Verarbeitungsschicht (3) in dem verarbeiteten Zustand ferner ein oder mehrere weitere reagierte Elemente (7) umfasst, die aus einem oder mehreren der nicht reaktiven Elemente (5) bei der Interaktion der reaktiven Elemente (4) mit der auftreffenden elektromagnetischen Strahlung (R) erzeugt werden, und ferner ein oder mehrere nicht reaktive Elemente (5) umfasst, die nicht interagieren, und
wobei die Verarbeitungsschicht (3) in dem verarbeiteten Zustand ferner mindestens ein Personalisierungselement (100) umfasst, wobei das Personalisierungselement (100) nicht interagierende, nicht reaktive Elemente (8) umfasst oder daraus besteht,
**dadurch gekennzeichnet, dass**
die reaktiven Elemente (4) und/oder die nicht reaktiven Elemente (5) in einem Gradienten bezüglich der Erstreckungsrichtung (E) und/oder bezüglich einer senkrecht zur Erstreckungsrichtung (E) verlaufenden Querrichtung (T) bereitgestellt sind.

27. Verfahren zum Personalisieren eines Datenträgers (1), vorzugsweise eines Datenträgers nach einem der Ansprüche 1 bis 25, wobei das Verfahren die folgenden Schritte umfasst:
- Bereitstellen von mindestens einem Trägerkörper (2); und
- Bereitstellen von mindestens einer Verarbeitungsschicht (3),
wobei die Verarbeitungsschicht (3) mindestens in einem unverarbeiteten Zustand der Verarbeitungsschicht (3) ein oder mehrere reaktive Elemente (4) und ein oder mehrere nicht reaktive Elemente (5) umfasst, und
wobei die reaktiven Elemente (4) konfiguriert sind, um bei einer Verarbeitung der Verarbeitungsschicht (3) mit auftreffender elektromagnetischer Strahlung (R) zu interagieren,
wobei das Verfahren ferner die folgenden Schritte umfasst:
- Einstrahlen elektromagnetischer Strahlung (R) auf die Verarbeitungsschicht (3), wodurch die Verarbeitungsschicht (3) sich in einem verarbeiteten Zustand befindet,
wobei die Verarbeitungsschicht (3) in dem verarbeiteten Zustand ein oder mehrere aus den reaktiven Elementen (4) erzeugte reagierte Elemente (6) umfasst,
wobei die Verarbeitungsschicht (3) in dem verarbeiteten Zustand ferner ein oder mehrere weitere reagierte Elemente (7) umfasst, die aus einem oder mehreren der nicht reaktiven Elemente (5) bei der Interaktion der reaktiven Elemente (4) mit der auftreffenden elektromagnetischen Strahlung (R) erzeugt werden, und ferner ein oder mehrere nicht reaktive Elemente (5) umfasst, die nicht interagieren, und
wobei in der Verarbeitungsschicht (3) in dem verarbeiteten Zustand mindestens ein Personalisierungselement (100) erzeugt wird, wobei das Personalisierungselement (100) die nicht interagierenden, nicht reaktiven Elemente (8) umfasst oder daraus besteht,
**dadurch gekennzeichnet, dass**
die reaktiven Elemente (4) und/oder die nicht reaktiven Elemente (5) in einem Gradienten bezüglich der Erstreckungsrichtung (E) und/oder bezüglich einer senkrecht zur Erstreckungsrichtung (E) verlaufenden Querrichtung (T) bereitgestellt sind.

## Revendications

1. Support de données (1) s'étendant le long d'une direction d'extension (E) et comprenant :
- au moins un corps de support (2) ; et
- au moins une couche de traitement (3),
dans lequel la couche de traitement (3), au moins dans un état non traité de la couche de traitement (3), comprend un ou plusieurs éléments réactifs (4) et un ou plusieurs éléments non réactifs (5),
dans lequel les éléments réactifs (4) sont configurés pour interagir avec un rayonnement électromagnétique incident (R) lors d'un traitement de la couche de traitement (3),
dans lequel la couche de traitement (3), dans un état traité de la couche de traitement (3), comprend un ou plusieurs éléments ayant réagi (6) étant générés à partir des éléments réactifs (4),
dans lequel la couche de traitement (3) dans l'état traité comprend en outre un ou plusieurs éléments ayant réagi supplémentaires (7) étant générés à partir d'un ou plusieurs des éléments non réactifs (5) lors de l'interaction des éléments réactifs (4) avec le rayonnement électromagnétique incident (R) et comprend en outre un ou plusieurs éléments non réactifs (5) restant sans interaction, et
dans lequel la couche de traitement (3) dans l'état traité comprend en outre au moins un élément de personnalisation (100), cet élément de personnalisation (100) comprenant ou consistant en les éléments non réactifs sans interaction (8),
**caractérisé en ce que**
les éléments réactifs (4) et/ou les éléments non réactifs (5) sont fournis dans un gradient par rapport à la direction d'extension (E) et/ou par rapport à une direction transversale (T) s'étendant perpendiculairement à la direction d'extension (E).

2. Support de données (1) selon la revendication 1, dans lequel la couche de traitement (3) dans son état non traité présente une première apparence et dans son état traité présente une seconde apparence, la première apparence et la seconde apparence différant l'une de l'autre.

3. Support de données (1) selon l'une quelconque des revendications précédentes,
dans lequel un ou plusieurs éléments non réactifs (5) sont d'une première apparence et au moins un ou plusieurs éléments non réactifs supplémentaires sont d'au moins une apparence supplémentaire, la première apparence et l'apparence supplémentaire différant l'une de l'autre.

4. Support de données (1) selon l'une quelconque des revendications précédentes,
dans lequel un ou plusieurs éléments non réactifs sans interaction (8) sont d'une première apparence et au moins un ou plusieurs éléments non réactifs sans interaction (8) supplémentaires sont d'au moins une apparence supplémentaire, la première apparence et l'apparence supplémentaire différant l'une de l'autre.

5. Support de données (1) selon l'une quelconque des revendications précédentes, dans lequel les éléments réactifs (4) et/ou les éléments non réactifs (5) sont répartis de façon régulière ou irrégulière dans la couche de traitement (3).

6. Support de données (1) selon l'une quelconque des revendications précédentes, dans lequel au moins l'un parmi les éléments non réactifs sans interaction (8), les éléments ayant réagi (6) et les éléments ayant réagi supplémentaires (7) sont répartis de façon régulière ou irrégulière dans la couche de traitement (3).

7. Support de données (1) selon l'une quelconque des revendications précédentes, dans lequel les éléments non réactifs sans interaction (8) et/ou les éléments ayant réagi (6) et/ou les éléments ayant réagi supplémentaires (7) sont fournis dans un gradient par rapport à la direction d'extension (E) et/ou par rapport à une direction transversale (T) s'étendant perpendiculairement à la direction d'extension (E).

8. Support de données (1) selon l'une quelconque des revendications 1 à 6, dans lequel au moins l'un parmi les éléments réactifs (4), les éléments non réactifs (5), les éléments non réactifs sans interaction (8), les éléments ayant réagi (6) et les éléments ayant réagi supplémentaires (7) sont répartis uniformément par rapport à la direction d'extension (E) et/ou par rapport à une direction transversale (T) s'étendant perpendiculairement à la direction d'extension (E).

9. Support de données (1) selon l'une quelconque des revendications précédentes, dans lequel les éléments réactifs (4) sont fournis dans un gradient et les éléments non réactifs (5) sont répartis uniformément par rapport à la direction d'extension (E) et/ou à une direction transversale (T) orientée perpendiculairement par rapport à la direction d'extension (E).

10. Support de données (1) selon l'une quelconque des revendications 1 à 8, dans lequel les éléments non réactifs (5) sont fournis dans un gradient et les éléments réactifs (4) sont répartis uniformément par rapport à la direction d'extension (E) et/ou à une direction transversale (T) orientée perpendiculairement par rapport à la direction d'extension (E).

11. Support de données (1) selon l'une quelconque des revendications précédentes, dans lequel dans l'état non traité de la couche de traitement (3) la quantité d'éléments non réactifs (5) est égale à ou est différente de la quantité d'éléments réactifs (4).

12. Support de données (1) selon l'une quelconque des revendications précédentes, dans lequel dans l'état non traité de la couche de traitement (3) la quantité d'éléments réactifs (4) représente au moins 10 % ou plus, de préférence au moins 20 % ou plus, en particulier de préférence au moins 25 % ou plus, de la quantité totale d'éléments réactifs (4) et d'éléments non réactifs (5).

13. Support de données (1) selon l'une quelconque des revendications précédentes, dans lequel le corps de support (2) comprend une surface supérieure (9), et dans lequel la couche de traitement (3) est agencée sur la surface supérieure (9) du corps de support (2).

14. Support de données (1) selon l'une quelconque des revendications précédentes, dans lequel l'élément de personnalisation (100) comprend une structure à relief (11), la structure à relief (11) étant de préférence fournie par les éléments non réactifs sans interaction (8) et éventuellement en outre par les éléments réactifs (4) et/ou les éléments ayant réagi (6) et/ou les éléments ayant réagi supplémentaires (7).

15. Support de données (1) selon l'une quelconque des revendications précédentes,
dans lequel la structure à relief (11)est fournie dans un gradient par rapport à la direction d'extension (E) et/ou par rapport à une direction transversale (T) s'étendant perpendiculairement à la direction d'extension (E).

16. Support de données (1) selon l'une quelconque des revendications précédentes, dans lequel la couche de traitement (3) est une impression, de préférence une impression à apparences multiples, telle qu'une impression multicolore.

17. Support de données (1) selon l'une quelconque des revendications précédentes,
dans lequel l'élément réactif (4) est sensible au rayonnement et/ou absorbe le rayonnement et/ou diffuse le rayonnement et/ou est fourni en tant qu'encre et/ou comprend un pigment réactif au rayonnement et/ou un additif réactif et/ou un colorant réactif.

18. Support de données (1) selon l'une quelconque des revendications précédentes, dans lequel l'élément non réactif (5) est non sensible au rayonnement et/ou n'absorbe pas le rayonnement et/ou ne diffuse pas le rayonnement et/ou est fourni en tant qu'encre, de préférence une encre d'impression à jet d'encre et/ou une encre de sérigraphie et/ou une encre représentant un effet spécial tel qu'une encre thermochromique et/ou une encre photochromique, et/ou une encre luminescente et similaires.

19. Support de données (1) selon l'une quelconque des revendications précédentes, dans lequel l'élément ayant réagi (6) et/ou l'élément ayant réagi supplémentaire (7) est un élément blanchi et/ou un élément ablaté et/ou un élément évaporé et/ou un élément dont la couleur a changé et/ou un élément opaque et/ou un élément bulleux et/ou un élément bombé et/ou un élément trouble et/ou un élément flou.

20. Support de données (1) selon l'une quelconque des revendications précédentes, dans lequel une taille d'au moins un parmi les éléments non réactifs (5), les éléments réactifs (4), les éléments non réactifs sans interaction (8), les éléments ayant réagi (6) et les éléments ayant réagi supplémentaires (7) est dans la plage de 30 micromètres à 1000 micromètres, de préférence dans la plage de 150 micromètres à 500 micromètres.

21. Support de données (1) selon l'une quelconque des revendications précédentes, dans lequel une taille d'au moins l'un parmi les éléments non réactifs (5), les éléments réactifs (4), les éléments non réactifs sans interaction (8), les éléments ayant réagi (6) et les éléments ayant réagi supplémentaires (7) est de 30 micromètres ou plus, de préférence 150 micromètres ou plus.

22. Support de données (1) selon l'une quelconque des revendications précédentes, dans lequel la couche de traitement (3) est continue ou intermittente par rapport à la direction d'extension (E) et/ou par rapport à une direction transversale (T) orientée perpendiculairement à la direction d'extension (E).

23. Support de données (1) selon l'une quelconque des revendications précédentes, comprenant en outre au moins une couche d'arrière-plan (12, 12a), dans lequel la couche d'arrière-plan (12, 12a) est agencée après la couche de traitement (3) par rapport à la direction d'extension (E), la couche d'arrière-plan (12, 12a) étant configurée pour réfléchir et/ou diffuser et/ou absorber un rayonnement électromagnétique incident (R).

24. Support de données (1) selon l'une quelconque des revendications précédentes,
dans lequel la couche d'arrière-plan (12, 12a) est non transparente ou transparente et/ou est une couche marquable par laser et/ou comprend au moins un composé métallique tel qu'une feuille métallique flexible de préférence mince ou une couche métallique rigide de préférence plus épaisse.

25. Document de sécurité (1000) comprenant ou consistant en au moins un support de données (1) selon l'une quelconque des revendications précédentes, le document de sécurité étant de préférence une carte bancaire, une carte d'identité, un passeport, une carte à puce, un permis de conduire, une page de données ou similaire.

26. Procédé de production d'un support de données (1), de préférence un support de données selon l'une quelconque des revendications précédentes, le procédé comprenant les étapes consistant à :
- fournir au moins un corps de support (2) ; et
- fournir au moins une couche de traitement (3),
dans lequel la couche de traitement (3), au moins dans un état non traité de la couche de traitement (3), comprend un ou plusieurs éléments réactifs (4) et un ou plusieurs éléments non réactifs (5),
dans lequel les éléments réactifs (4) sont configurés pour interagir avec un rayonnement électromagnétique incident (R) lors d'un traitement de la couche de traitement (3),
dans lequel la couche de traitement (3), dans un état traité de la couche de traitement (3), comprend un ou plusieurs éléments ayant réagi (6) étant générés à partir des éléments réactifs (4),
dans lequel la couche de traitement (3) dans l'état traité comprend en outre un ou plusieurs éléments ayant réagi supplémentaires (7) étant générés à partir d'un ou plusieurs des éléments non réactifs (5) lors de l'interaction des éléments réactifs (4) avec le rayonnement électromagnétique incident (R) et comprend en outre un ou plusieurs éléments non réactifs (5) restant sans interaction, et
dans lequel la couche de traitement (3) dans l'état traité comprend en outre au moins un élément de personnalisation (100), cet élément de personnalisation (100) comprenant ou consistant en les éléments non réactifs sans interaction (8),
**caractérisé en ce que**
les éléments réactifs (4) et/ou les éléments non réactifs (5) sont fournis dans un gradient par rapport à la direction d'extension (E) et/ou par rapport à une direction transversale (T) s'étendant perpendiculairement à la direction d'extension (E).

27. Procédé de personnalisation d'un support de données (1), de préférence un support de données selon l'une quelconque des revendications 1 à 25, le procédé comprenant les étapes consistant à :
- fournir au moins un corps de support (2) ; et
- fournir au moins une couche de traitement (3),
dans lequel la couche de traitement (3), au moins dans un état non traité de la couche de traitement (3), comprend un ou plusieurs éléments réactifs (4) et un ou plusieurs éléments non réactifs (5), et
dans lequel les éléments réactifs (4) sont configurés pour interagir avec un rayonnement électromagnétique incident (R) lors d'un traitement de la couche de traitement (3),
le procédé comprenant en outre l'étape consistant à :
- irradier un rayonnement électromagnétique (R) sur la couche de traitement (3), moyennant quoi la couche de traitement (3) est dans un état traité,
dans lequel la couche de traitement (3) dans l'état traité comprend un ou plusieurs éléments ayant réagi (6) étant générés à partir des éléments réactifs (4),
dans lequel la couche de traitement (3) dans l'état traité comprend en outre un ou plusieurs éléments ayant réagi supplémentaires (7) étant générés à partir d'un ou plusieurs des éléments non réactifs (5) lors de l'interaction des éléments réactifs (4) avec le rayonnement électromagnétique incident (R) et comprend en outre un ou plusieurs éléments non réactifs (5) restant sans interaction, et
dans lequel au moins un élément de personnalisation (100) est généré dans la couche de traitement (3) dans l'état traité, cet élément de personnalisation (100) comprenant ou consistant en les éléments non réactifs sans interaction (8),
**caractérisé en ce que**
les éléments réactifs (4) et/ou les éléments non réactifs (5) sont fournis dans un gradient par rapport à la direction d'extension (E) et/ou par rapport à une direction transversale (T) s'étendant perpendiculairement à la direction d'extension (E).
